Europäisches Patentamt

European Patent Office

Office européen des brevets

(11) Publication number: **0 444 768 A1**

# EUROPEAN PATENT APPLICATION

(21) Application number: **91300273.9**

(51) Int. Cl.5: **H05K 9/00**

(22) Date of filing: **15.01.91**

(30) Priority: **31.01.90 GB 9002121**

(43) Date of publication of application:
**04.09.91 Bulletin 91/36**

(84) Designated Contracting States:
**DE FR GB IT**

(71) Applicant: **LUCAS INDUSTRIES PUBLIC LIMITED COMPANY**
**Brueton House, New Road**
**Solihull, West Midlands B91 3TX(GB)**

(72) Inventor: **Maker, Paul Manwaring**
**27 Ladd Street**
**Pequannock NJ 07440(US)**

(74) Representative: **Robinson, John Stuart et al**
**Marks & Clerk Alpha Tower Suffolk Street**
**Queensway**
**Birmingham, B1 1TT(GB)**

(54) Screening arrangement.

(57) A screening arrangement for screening an electronic circuit (26) from electromagnetic interference comprises a chassis (21) and a lid (23) with dividing walls forming four mutually screened compartments (25, 29-31). A multilayer circuit board (32) carrying interconnections (65, 67) and ground planes (61-63) extends through the dividing walls into all of the compartments and connects to the electronic circuit (26) in the first compartment (25) and a connector (38) in the fourth compartment (31). The circuit board (32) carries interference filters (36) in the second compartment (29) and voltage limiters (37) in the third compartment (30).

FIG 3

SCREENING ARRANGEMENT

The present invention relates to a screening arrangement, for instance for screening an electronic circuit and connections thereto from interference.

In aerospace applications, electronic circuits, such as control units for engines, require screening against interference so as to ensure correct operation. In the case of an aircraft having an engine control unit, the electronic circuits and components within the control unit are enclosed in a screened case but require protection against the effects of, for instance, lightning strikes. In cases where the airframe of the aircraft is made mostly of metal, the lightning current spreads into the metal skin and its energy is dissipated at the sharp edges of the airframe. The energy is therefore attenuated before being electromagnetically coupled into wiring harnesses connected to the control unit.

In the case of an airframe which is mostly non-metallic, the initial attenuation caused by a metal skin does not occur. A high voltage pulse is therefore coupled into the leads of the harness and, without some form of protection, could easily damage filter components and connectors within the control unit.

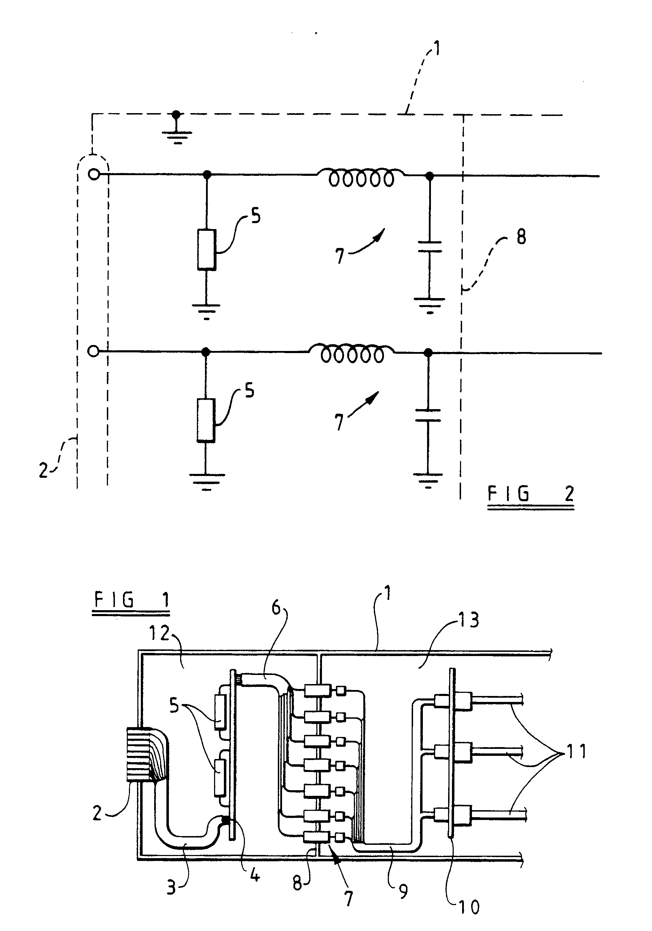

Figure 1 of the accompanying drawings illustrates a known screening arrangement for a control unit of an aircraft engine. The arrangement comprises a metal case 1 provided with a multi-pin connector 2 for input and output signals. The pins of the connector 2 are connected by a multicore harness 3 to a printed circuit board 4 which carries a plurality of over-voltage protectors 5 with one for each lead of the harness 3.

The over-voltage protectors 5 are, for instance, transient suppression diodes connected between each lead and the case. The printed circuit board 4 is connected by another multicore harness 6 to a plurality of radio frequency interference filters 7 which are mounted in and pass through a specially machined metal plate 8 fixed to the case 1. The filters 7 comprise ceramic capacitors connected between each lead and earth (the metal plate 8) and ferrite beads through which the leads pass. The leads from the filters 7 are then formed into another multicore harness 9 which is connected to a motherboard 10 into which a plurality of circuit boards 11 are plugged by means of mating connectors.

In the event of a lightning strike affecting the connections to the control unit, the amplitude of the pulse or spike is limited to a safe value by the transient suppression diodes 5. The signals from the transient suppression diodes 5 are contaminated with radio frequency inference (RFI) which is suppressed or attenuated by the filters 7. The plate 8, which may be integral with the case 1, provides a screen between the electronic circuit on the circuit boards 10 and 11 and the "noisy" signals in the harnesses 3 and 6 by dividing the case 1 into a first enclosure 12 and a second enclosure 13, each of which is effectively a Faraday cage.

Figure 2 of the accompanying drawings is a circuit diagram of this screening arrangement showing the voltage limiting and filtering components for two of the leads from the connector 2 to the electronic control unit.

Although this arrangement works well, it has several disadvantages. Three multicore harnesses 3, 6, and 9 are required in order to interconnect the various components between the connector 2 and the motherboard 10. This requires the making of a large number of connections, and therefore makes the arrangement complicated and expensive to manufacture. The plate 8 has to be specially machined and expensively packaged filters have to be mounted thereon. Also, the transient suppression diodes 5 have to be mounted on the circuit board 4 in a separate step. This arrangement is therefore expensive and inconvenient to manufacture.

EPO 350775 discloses an arrangement in which an enclosure is divided into two mutually screened compartments by a multilayer circuit board having an internal layer ground plane acting as a screen. Signals pass through the board substantially perpendicularly to the ground plane and filter components, such as surface mount devices, are mounted on both sides of the board.

Such an arrangement requires the use of surface mount components in order to preserve the screening effect of the ground plane. In particular, through-board mounted components would have leads which projected into the compartment on the opposite side of the board from the component body. Such projections would act as antennae for transmitting and/or receiving electromagnetic interference, which would thus pass through the ground plane and contaminate the compartment containing the circuit board. The exclusive use of surface mount components limits the choice of components which may be mounted on the board and can limit the effectiveness of the filter, particularly at high frequencies.

The effectiveness of the screening between the two compartments is largely dependent on the integrity of the ground plane and on its electrical connection around its edge to the enclosure walls. Poor or discontinuous peripheral connection can permit electromagnetic interference to seep between the compartments and a single ground plane screening layer formed as a printed circuit layer may not provide sufficient attenuation of electromagnetic interference.

EP 0181286 discloses another arrangement in which an enclosure is divided into two compartments by a multilayer circuit board and signals pass through the board perpendicularly to the plane of the board. The terminals of an input connector pass through the board and act as antennae which radiate interference into the "clean" compartment. Further, ground planes provided by the board are not connected around the whole periphery of the board to the enclosure, so that electromagnetic interference can seep around the edges of the board into the clean compartment.

According to the invention, there is provided a screening arrangement comprising a first screened enclosure for containing an electronic circuit, a second screened enclosure containing at least one interference reducing filter electrically connected to the electronic circuit, and a first connector electrically connected to the at least one filter, characterized in that the first and second enclosures are separated by a first common screening wall and in that the at least one filter is mounted on a circuit board which extends through the first wall into the first and second enclosures and which carries electrically conductive interconnections for connecting the at least one filter to the electronic circuit and the first connector.

Preferably the screening arrangement comprises a third screened enclosure containing at least one over-voltage limiter, the circuit board extending into the third screened enclosure and carrying the at least one over-voltage limiter which is electrically connected to the first connector and, via the electrically conductive interconnections, to the at least one filter.

Preferably the circuit board is a printed circuit board, such as a multilayer printed circuit board. Preferably the circuit board has a first layer for providing electrical connections between the first connector and the at least one filter, and a second layer for providing electrical connection between the at least one filter and the electronic circuit. Preferably the circuit board has a plurality of ground planes. Preferably, a first ground plane is disposed between the first and second layers which are surrounded by second and third ground planes, respectively.

Preferably the circuit board carries a second connector for providing electrical connection to the electronic circuit. Preferably the electronic circuit includes a motherboard which has a third connector mating with the second connector.

Preferably the first connector is disposed in a fourth screened enclosure into which the circuit board extends.

Preferably a case, for instance made of metal, is partitioned so as to form the first and second enclosures and, when present, the third and fourth enclosures. Preferably the case comprises a chassis and a removable cover which define therebetween the second enclosure and, when present, the third and fourth enclosures. Preferably the circuit board is sandwiched between the chassis and the cover and is provided with RFI gaskets. Preferably an earthed screening plate covers the connections between the circuit board and the at least one filter and, when the second connector is present, the connections between the circuit board and the second connector. The plate may be provided with holes or recesses for accommodating the connections without making electrical contact therewith.

It is thus possible to provide a simplified screening arrangement which is substantially less expensive to produce than known arrangements without significantly sacrificing the screening ability. At least two of the wiring harnesses of one type of known screening arrangement can be eliminated, thereby greatly simplifying the wiring of the arrangement during manufacture. Further, the circuit board for the transient suppression diodes and the specially machined plate for the filters can be eliminated, again simplifying assembly. Most or all of the components can be mounted on circuit boards which can be arranged to plug into each other so that only a single wiring harness from the first connector to the substrate is required. If desired, this can also be eliminated by using a connector which can be mounted directly on a printed circuit board. Thus, most or all of the connections which have to be made during manufacture of the known screening arrangement can be eliminated and the screening arrangement can be manufactured by assembling a circuit board in known manner and plugging and bolting together the various sub-assemblies. Manufacture is therefore simplified, reliability is increased by reducing or eliminating connections to the circuit board, and the arrangement can be manufactured at greatly reduced cost compared with the known arrangement.

The invention will be further described, by way of example, with reference to the accompanying drawings, in which:

Figure 1 is a cross-sectional view of a known screening arrangement;

Figure 2 is a circuit diagram of the screening arrangement of Figure 1;

Figure 3 is a cross-sectional view of a screening arrangement constituting a preferred embodiment of the present invention;

Figure 4 is a plan view of an input layer of a circuit board of Figure 3;

Figure 5 is a plan view of an output layer of the circuit board of Figure 3;

Figure 6 is a plan view of a screening plate of the arrangement of Figure 3; and

Figure 7 is a cross-sectional view of the circuit board of Figure 3;

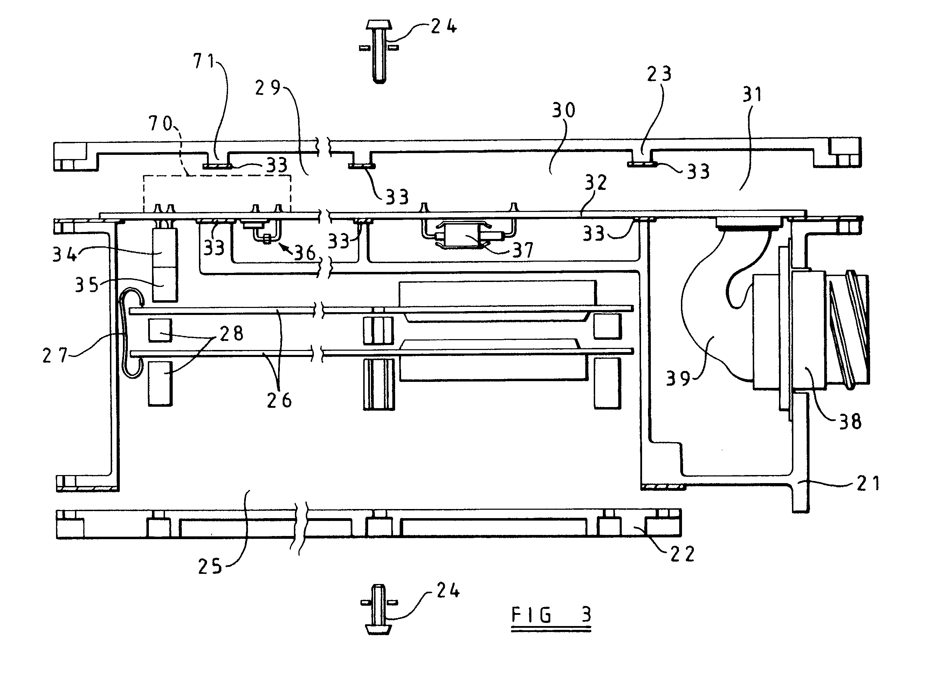

The screening arrangement shown in Figure 3 comprises a metal case comprising a chassis 21, a bottom cover 22, and a top cover 23, held together by bolts and washers 24 to form a metal screening case acting as a Faraday cage and containing various mutually screened enclosures. A first enclosure 25 contains an electronic circuit, for instance constituting a control circuit for an aero-engine. The electronic circuit is arranged on a plurality of printed circuit boards 26 interconnected by ribbon cables 27, connectors 28, or by being plugged into a common motherboard (not shown).

The chassis 21 and the top cover 23 carry a plurality of walls which, when assembled, divide the upper part of the case into a second enclosure 29, a third enclosure 30, and a fourth enclosure 31. A multilayer printed circuit board 32 is sandwiched between the chassis 21 and the top cover 23 together with a plurality of RFI gaskets 33.

The printed circuit board 32 carries a connector 34 which mates with a connector 35 mounted on one of the circuit boards 26 so as to provide input and/or output connections for the electronic circuit within the first enclosure 25.

RFI filter components 36 and transient suppression diodes 37 are mounted on and interconnected by the printed circuit board 32. The circuit board 32 is connected to a connector 38 by means of a multicore wiring harness 39.

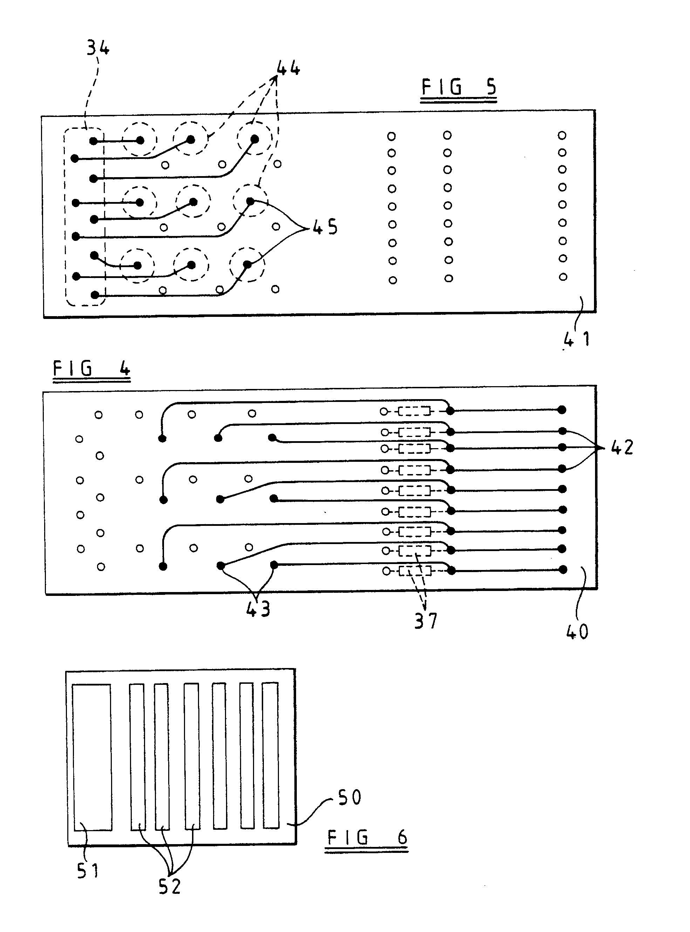

Figure 4 shows the input connections formed as a first or input layer 40 of the printed circuit board 32 and Figure 5 shows a similar view of a second or output layer 41. The black circles in Figures 4 and 5 illustrate connections made to the respective layer whereas the white circles illustrate through-holes with no connection made in that layer.

The wiring harness 39 from the connector 38 is connected to a plurality of pins 42 soldered to printed circuit tracks of the input layer. These tracks are connected to first terminals of respective transient suppression diodes 37, whose other terminals are connected to ground planes as will be described hereinafter. In order to avoid the through-holes for the earthed terminals of the diodes 37, the printed circuit tracks of the input layer are offset and are connected to the first legs 43 of U-shaped staples which connect the input tracks to the filter components and the output layer.

Each filter includes an annular ceramic capacitor 44 whose radially outer and inner surfaces are metallised to form capacitor plates. Second legs 45 of the staples are soldered to the inner plates of the capacitors 44 and to the printed circuit tracks of the output layer as shown in Figure 5. These tracks are connected to the pins of the connector 34.

In order to improve the screening or, where necessary, to provide adequate screening against RFI, a screening plate 50 may be placed on top of the printed circuit board 32. The plate 50 is provided with a recess or hole 51 in order to clear the pins of the connector 34 and with a plurality of recesses or holes 52 in order to clear the legs 43 and 45 of the staples where these protrude above the circuit board 32. The upper ends of the staples act as aerials for transmitting RFI and the upper ends of the pins of the connector 34 act as aerials for receiving this RFI. The metal screening plate 50, which is connected electrically to the case, screens these transmitting and receiving antennae from each other and thus provides further attenuation of RFI.

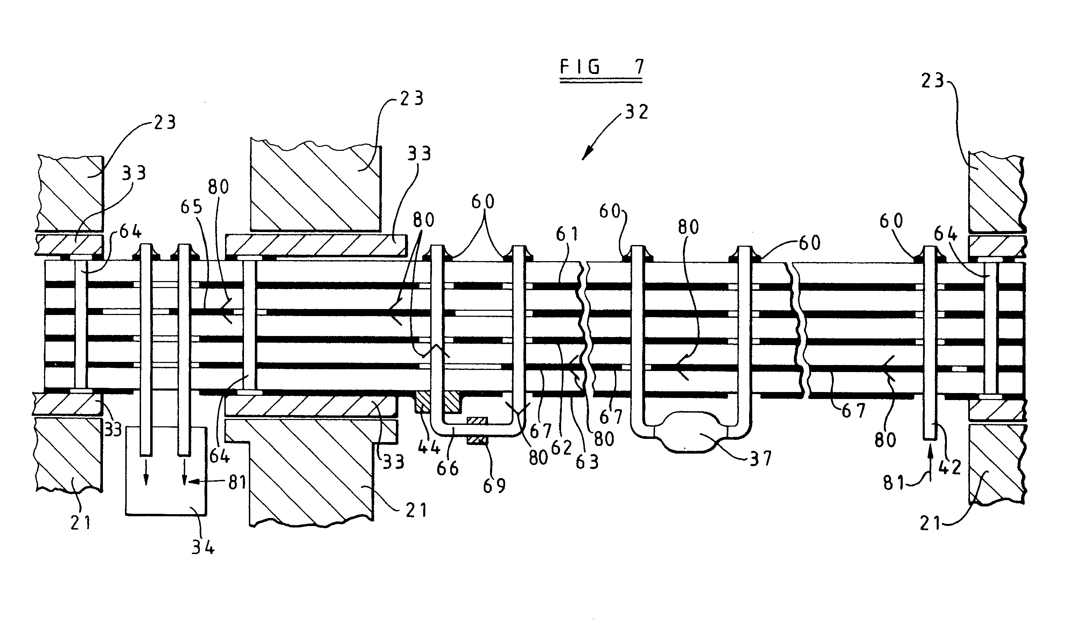

The printed circuit board 32 is shown in greater detail in the cross-sectional view of Figure 7. The board is a multilayer board comprising six conductive layers separated by dielectric or insulating layers. This board may be formed from a double layer printed circuit board and four single layer printed circuit boards stacked together to form a laminar structure. The dielectric material may, for instance, be resin and glass fibre and the conductive layers may be formed of copper with patterns printed in the known way to define tracks, component pads, and ground planes. Thus, the upper conductive layer is arranged to provide component pads 60 which serve merely for anchoring pins of components attached to the board 32. A second layer 61, a fourth layer 62, and a sixth layer 63 form three ground planes which are electrically connected together and to the case via the RFI gaskets 33 by conductive pins 64. The third layer 65 is the output layer and electrically connects the second limbs of the staples 66 to the pins of the connector 34. Although not shown in Figure 5, portions of this layer not required for providing the output connections may be arranged as a further ground plane and this is illustrated in Figure 7. The fifth layer provides the input connections 67 from the pins 42 to the transient suppression diodes 37 and the first limbs of the staples 66 and, similarly, those portions not required for providing input connection may be used as a ground plane as shown in Figure 7.

The pins 42 are connected to the tracks 67 and to the component pads 60. First leads of the diodes 37 are likewise connected to the input tracks 67 and the pads 60 whereas the second leads of the diodes 37 are connected to all of the ground planes and to the pads 60. The first limbs of the staples 62 are connected to the input tracks 67 and to the pads 60 whereas the second limbs are connected to the output tracks 65 and the pads 60. In addition, the second limb of each staple 66 is soldered to the metallised hole forming the first plate connection of the respective ceramic capacitor 44, whose outer curved surface is metallised to form the second plate connection and is soldered to the ground plane 63. A first ring inductor is provided in the form of a ferrite bead 69 threaded onto the portion of the staple connecting the limbs together.

The pins of the connector 34 are soldered to the output tracks 65 and to the pads 60.

The signal flow is illustrated by arrowheads 80 and arrows 81 in Figure 7.

The printed circuit board 32 may be formed in the conventional manner. Thus, each of the individual boards is initially etched to provide the desired pattern of conductive areas and drilled so as to accommodate the pins and leads of the components. The patterns of conductive areas for the ground planes 61, 62, and 63 are the same and the pattern of holes is the same for all of the individual circuit boards. The various components are mounted on the circuit boards which are then assembled together with the holes in registration. The thus-assembled multilayer board is then flow-soldered in order to form the finished multilayer printed circuit board 32. Where necessary, the holes may be through-plated.

In the screening arrangement shown in Figure 3, the only electrical connections which need to be made are those between the circuit board 32 and the connector 38. Thus, the wiring harness 39 has to be soldered to the pins 42 and the pins of the connector 38. Once the circuit boards 26 have been inserted in the first enclosure 25, these boards are connected to the circuit boards 32 by mating of the connectors 34 and 35. The covers 22 and 23 are then bolted in place to provide the finished assembly. If necessary or desirable, the screening plate 50 is arranged between the circuit board 32 and the top cover 23 as indicated in Figure 3 by the broken lines 70, in which case the wall 71 can be reduced in size or eliminated so as to accommodate the plate.

It is thus possible to provide a screening arrangement which is quick, easy, and relativity cheap to manufacture. The number of electrical connections which have to be made is greatly reduced and can even be eliminated by providing a connector 38 of the type which can be connected directly to the circuit board 32, although this may not be convenient for positioning of the connector 38. Individually wired interconnections between the board 32 and the electronic circuit within the first enclosure 25 can be eliminated by providing the mating connectors 34 and 35. The electronic circuit is screened from RFI by providing the RFI filters 36 in the second enclosure 29 and, if necessary, providing the screening plate 50. The multiple ground planes of the circuit board 30 also assists in providing adequate screening.

Although an embodiment incorporating components for through-hole fixing has been described, surface mount components may be used in place of some or all of the through-hole components.

## Claims

1. A screening arrangement comprising a first screened enclosure for containing an electronic circuit, a second screened enclosure containing at least one interference reducing filter electrically connected to the electronic circuit, and a first connector electrically connected to the at least one filter, characterized in that the first and second enclosures (25, 29) are separated by a first common screening wall (71) and in that the at least one filter (36) is mounted on a circuit board (32) which extends through the first wall (71) into the first and second enclosures (25, 29) and which carries electrically conductive interconnections (65, 67) for connecting the at least one filter (36) to the electronic circuit (26) and to the first connector (38).

2. A screening arrangement as claimed in Claim 1, characterized by a third screened enclosure (30) separated from the second enclosure (29) by a second common screening wall through which the circuit board (32) extends, and by at least one over-voltage limiter (37) which is mounted on the circuit board (32) in the third enclosure (30) and connected to the at least one filter (36) and the first connector (38) via the electrically conductive interconnections (67).

3. A screening arrangement as claimed in Claim 2, characterized by a fourth screened enclosure (31) separated from the third enclosure (30) by a third common screening wall through which the circuit board (32) extends, the first connector (38) extending into the fourth screened enclosure (30).

4. A screening arrangement as claimed in any one of the preceding claims, characterized in that the first enclosure (25) contains a second connector (34) mounted on the circuit board (32) for connection to the electronic circuit (26).

5. A screening arrangement as claimed in any one of the preceding claims, characterized in that the screened enclosures (25, 29, 30, 31) are provided by a chassis (21) divided into compartments by first wall portions and a cover (23) having second wall portions which, together with the first wall portions, provide the common screening walls, the circuit board (32) being sandwiched between the first and second wall portions.

6. A screening arrangement as claimed in any one of the preceding claims, characterized in that the circuit board (32) is a multilayer circuit board having a plurality of ground planes (61, 62, 63) surrounding the electrically conductive interconnections (65, 67).

7. A screening arrangement as claimed in Claim 6, characterized in that the electrically conductive interconnections (65, 67) comprise first interconnections (65) for connecting the at least one filter (36) to the electronic circuit (26) and second interconnections (67) for connecting the at least one filter (36) to the first connector (38), the first interconnections (65) being disposed between a first (61) and a second (62) of the ground planes and the second interconnections (67) being disposed between the second (62) and a third (63) of the ground planes.

8. A screening arrangement as claimed in Claim 7, characterized by fourth and fifth ground planes disposed in the planes of the first and second interconnections (65, 67), respectively, and laterally separate therefrom.

9. A screening arrangement as claimed in any one of the preceding claims, characterized in that the at least one filter (36) has lead ends projecting from the circuit board (32) and enclosed by a first screening plate (50).

10. A screening arrangement as claimed in Claim 4 or in any one of Claims 5 to 9 when dependent on Claim 4, characterized in that the second connector (34) has connection ends projecting from the circuit board (32) and enclosed by a second screening plate (50).

11. A screening arrangement as claimed in Claim 10 when dependent on Claim 9, characterized in that the first and second screening plates are provided by a common screening plate (50) extending through the first wall (71).

F I G   2

F I G   1

FIG 3

FIG 5

FIG 4

FIG 6

FIG 7

## DOCUMENTS CONSIDERED TO BE RELEVANT

EP 91300273.9

| Category | Citation of document with indication, where appropriate, of relevant passages | Relevant to claim | CLASSIFICATION OF THE APPLICATION (Int. Cl.5) |
|---|---|---|---|
| D,A | EP - A2/A3 - 0 350 775 (BODENSEEWERK) <br> * Abstract; fig. 1-3 * | 1-11 | H 05 K 9/00 |
| D,A | EP - A1 - 0 181 286 (AUTOPHON) <br> * Abstract; fig. 1,2; claims 1-5 * | 1-11 | |
| A | DE - B2 - 2 323 445 (SIEMENS) <br> * Claims 1-2; fig. 1-5 * | 1-11 | |
| A | DE - A1 - 2 949 848 (TEKADE) <br> * Claims 1-6; fig. 2 * | 1-11 | |
| A | DE - A1 - 3 223 355 (RACAL-DANA) <br> * Abstract; fig. 1-4 * | 1-11 | |

**TECHNICAL FIELDS SEARCHED (Int. Cl.5)**

H 05 K 9/00

The present search report has been drawn up for all claims

| Place of search | Date of completion of the search | Examiner |
|---|---|---|
| VIENNA | 14-03-1991 | VAKIL |